# EUROPEAN PATENT SPECIFICATION

(11) **EP 4 282 507 B1**
(45) Date of publication and mention of the grant of the patent: **07.05.2025**
(21) Application number: 21946846.9
(22) Date of filing: 09.12.2021
(51) Int. Cl.: B01D 36/00, B01D 53/04, H01J 37/30, H01J 37/305, H01J 37/32

(54) **METHOD FOR REDUCING AGGLOMERATION OF SILVER ETCHING BY-PRODUCTS**
VERFAHREN ZUR VERRINGERUNG DER AGGLOMERATION VON SILBERÄTZNEBENPRODUKTEN
PROCÉDÉ DE RÉDUCTION DE L'AGGLOMÉRATION DE SOUS-PRODUITS DE GRAVURE D'ARGENT

(30) Priority: 25.06.2021 CN 202110709703
(43) Date of publication of application: 29.11.2023
(73) Proprietor: Jiangsu Leuven Instruments Co. Ltd, Xuzhou, Jiangsu 221300 (CN)
(72) Inventor: ZHENG, Zhiyuan, Xuzhou, Jiangsu 221300 (CN); YANG, Yuxin, Xuzhou, Jiangsu 221300 (CN); LI, Jiahe, Xuzhou, Jiangsu 221300 (CN); PENG, Taiyan, Xuzhou, Jiangsu 221300 (CN); XU, Kaidong, Xuzhou, Jiangsu 221300 (CN)
(74) Representative: HGF
(86) International application number: PCT/CN2021/136770
(87) International publication number: WO 2022/267372

(56) References cited:
- CN-A- 101 072 620
- CN-A- 112 563 134
- CN-U- 210 325 685
- CN-U- 210 325 685
- US-A1- 2019 371 574
- WU, XIANGMEI ET AL.: "ADSORPTION OF SILVER ONTO THIOL-RESIN AND ITS MECHANISM", JOURNAL OF CHEMICAL INDUSTRY AND ENGINEERING, vol. 54, no. 10, 31 October 2003 (2003-10-31), pages 1466 - 1469, XP093016631, ISSN: 0438-1157
- ZHANG, JING ET AL.: "Adsorption behavior of silver by thiol-functionalized composite microspheres", SCIENCE AND TECHNOLOGY OF FOOD INDUSTRY, vol. 37, no. 16, 30 April 2016 (2016-04-30), pages 151 - 156, XP093016635, ISSN: 1002-0306

## Description

### CROSS-REFERENCE TO RELATED APPLICATION

This application claims priority to Chinese patent application NO. 2021107097031 filed on June 25, 2021 and entitled "METHOD FOR REDUCING AGGLOMERATION OF SILVER ETCHING BY-PRODUCTS".

### TECHNICAL FIELD

The present disclosure belongs to the technical field of silver etching, and particularly relates to a method for reducing agglomeration of silver etching by-products.

### BACKGROUND

The precious metal IBE benefits from the unique nanoscale after etching, which distinguishes from other nanomaterials in terms of light reflection, scattering, and resonance. And the surface plasmon resonance is the most fundamental characteristic.

The existing method for preparing the silver etching nano material can be divided into dry etching and wet etching. The advantages of the wet etching are high etching rate, high selectivity ratio and simpler equipment, for example, silver nano-sheets are prepared at the room temperature by adopting silver NO₃, sodium citrate, H₂O₂ and NaBH₄ solutions. But the disadvantage of the wet etching is also evident, and the wet etching is typically isotropic, which causes the etchant chemistry to remove the substrate material beneath the mask material. Wet etching further requires a large amount of chemistry, because the substrate material must be covered by the etchant. In addition, the etchant must be replaced consistently to maintain the same initial etching rate. This results in extremely high production costs associated with wet etching.

Ion Beam Etching (IBE) is a kind of dry etching, and is a device that bombards the surface of a material with an ion beam of a certain energy to sputter the surface of the material, thereby implementing an etching effect.

The etching process flow is as follows.

Gas such as Ar, O₂ enters a quartz cavity discharge chamber- high-frequency waves initiated by an RF coil ionize Ar and O₂ to generate plasma-ions are gathered into ion beams with positive charges through a grid mesh→the ion beams with the positive charges are neutralized by electrons emitted by a neutralizer to form neutral ion beams→the neutral ion beams bombard the wafer on the carrying platform, and by-products are pumped away by a vacuum system.

Compared with wet etching, ion beam etching consumes less material, can etch the material from different directions, and has a lower production cost. However, when ion beam etching works, silver bombarded by the ion beam forms conductive agglomeration, and the agglomeration may remain on the surface of the etching material or be pumped away by a vacuum system into a dry pump, thereby shortening the service life of the equipment.

At present, in order to solve the problems of silver agglomeration and by-products in the etching process, a solution in the industry is to add a filter screen in a vacuum tube of a vacuum system to block particles which may enter a dry pump and a molecular pump, and the limitation of the method is that the size of the filter screen cannot be small enough, and the filter screen cannot block particles smaller than the aperture size of the filter screen. From CN 210 325 685 U an ion etching system with a filter element is known. US 2019/371574 A1 relates to an ion beam etching system with baffles to trap byproducts,

### SUMMARY

The exemplary embodiments of the present disclosure provide a method for reducing the aggregation of silver etching by-products, which can filter or adsorb most of the silver by-products.

An embodiment of the disclosure provides a method for reducing the agglomeration of silver etching by-products. The method includes the following steps.

In Step 1, at least one group of filter screen groups is provided in a vacuum tube connecting a dry pump and an IBE chamber, an interval between adjacent filter screen groups of the at least one group of filter screen groups is 50 mm to 500 mm, each group of filter screen groups includes 1 to 3 layers of filter screens, and an interval between adjacent filter screens is 0.5 mm to 5 mm.

In Step 2, a chemical adsorbent is filled between the filter screens.

In one embodiment, in Step 1, the groups of filter screen groups are provided with at least 2 groups.

In one embodiment, in Step 2, the chemical adsorbent includes an active component and a carrier, the active component includes any one or more of 30 wt% to 80 wt% of sulfhydryl compound, 10 wt% to 30 wt% of biomass charcoal and 10 wt% to 30 wt% of alkali metal compound.

In one embodiment, in Step 2, the carrier includes 20 wt% to 30 wt% of activated carbon, 5 wt% to 15 wt% of molecular sieve and 40 wt% to 80 wt% of alumina, and the loading amount of the active component is 10 wt% to 50 wt%.

In one embodiment, the sulfhydryl compound includes one or more of 3-mercaptopropyltrimethoxysilane, mercaptopropionic acid, mercaptoethylamine, glutathione and cellulose PWP-OX-TSC crosslinked based on sulfhydryl modified glutaraldehyde.

In one embodiment, the alkali metal compound includes one or more of magnesium oxide, calcium oxide and chromium hemitrioxide.

In one embodiment, the chemical adsorbent is spherical, granular, columnar or strip-shaped.

In one embodiment, the material of the filter screen is stainless steel, quartz or ceramic.

In one embodiment, aperture sizes of the filter screens in each filter screen group are sequentially reduced from an outer filter screen to an inner filter screen, an aperture size of an outermost filter screen is 2 mm to 5 mm, and an aperture size of an innermost filter screen is 0.5 mm to 1.5 mm.

In one embodiment, meshes of the adjacent filter screens are distributed in a staggered manner.

Compared with the prior art, the present disclosure has the following technical effects by adopting the above technical solutions.

The silver by-products of the present disclosure are filtered through a filter screen, and the large particles are blocked, after the small particles pass through the filter screen, due to the increase in the loading capacity of the active component of the adsorbent, there will be a better absorption effect on small particles of silver. The silver particles generated during the IBE etching process can be completely removed

### BRIEF DESCRIPTION OF THE DRAWINGS

FIG. 1 illustrates a schematic view of an IBE chamber in connection with a vacuum system in an embodiment of the present disclosure.
FIG. 2 illustrates a schematic view of a filter screen structure of the embodiment in FIG. 1.
FIG. 3 illustrates a schematic diagram of the PWP-OX-TSC chemisorption principle of the embodiment in FIG. 1.
FIG. 4 illustrates a schematic structural diagram of a silver etching material.

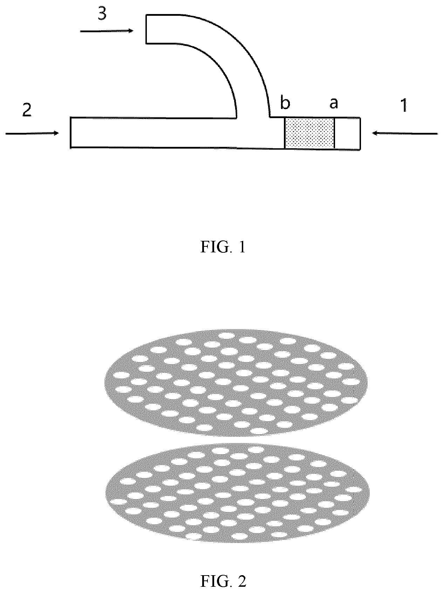

In FIG. 1, the reference number 1 represents a connection to the IBE chamber, the reference number 2 represents a connection to the dry pump, and the reference number 3 represents a connection to the molecular pump.

### DETAILED DESCRIPTION OF THE EMBODIMENTS

The technical solutions of the present disclosure are further explained in detail in combination with the accompanying drawings.

In the descriptions of the present disclosure, it should be understood that the terms such as "left side", "right side", "upper part", "lower part", indicate orientations or positional relationships based on those shown in the accompanying drawings, and are merely for the convenience of describing the present disclosure and simplifying the descriptions, but do not indicate or imply that the referred device or element must have a specific orientation, be constructed in a specific orientation, or be operated, and that "first", "second", etc., do not represent an important degree of the component parts, and thus should not be construed as limiting the present disclosure. The specific sizes used in this embodiment are merely for illustrating the technical solutions and do not limit the protection scope of the present disclosure.

The embodiment as illustrated in FIGS 1, 2, and 3 provides a method for reducing agglomeration of silver etching by-products. The method comprises the following steps.

In Step 1, two groups of filter screen groups (a and b) are provided in a vacuum tube connecting a dry pump and an IBE chamber, the interval between the adjacent filter screen groups is 50 mm to 500 mm, each group of filter screen groups includes 1 to 3 layers of filter screens, and an interval between adjacent filter screens is 0.5 mm to 5 mm.

In Step 2, a chemical adsorbent is filled between the filter screens.

In Step 2, the chemical adsorbent includes an active component and a carrier, the active component includes 30 wt% to 80 wt% of a sulfhydryl compound, 10 wt% to 30 wt% of biomass charcoal and 10 wt% to 30 wt% of an alkaline metal compound, the carrier includes 20 wt% to 30 wt% of active carbon, 5 wt% to 15 wt% of a molecular sieve and 40 wt% to 80wt% of alumina, and the loading amount of the active component is an arbitrary one or combination of 10 wt% to 50wt%.

The sulfhydryl compound includes one or more of 3-mercaptopropyltrimethoxysilane, mercaptopropionic acid, mercaptoethylamine, glutathione and cellulose PWP-OX-TSC crosslinked based on sulfhydryl modified glutaraldehyde.

The alkaline metal compound includes one or more of magnesium oxide, calcium oxide and chromium hemitrioxide.

The chemical adsorbent is spherical, granular, columnar or strip-shaped.

As illustrated in FIG. 2, the aperture sizes of the filter screens in each filter screen group are sequentially reduced from outside to inside, the aperture size of the outermost filter screen is 2 mm to 5 mm, and the aperture size of the innermost filter screen is 0.5 mm to 1.5 mm. The meshes of the adjacent filter screens are distributed in a staggered way. The material of the filter screen is stainless steel, quartz or ceramic.

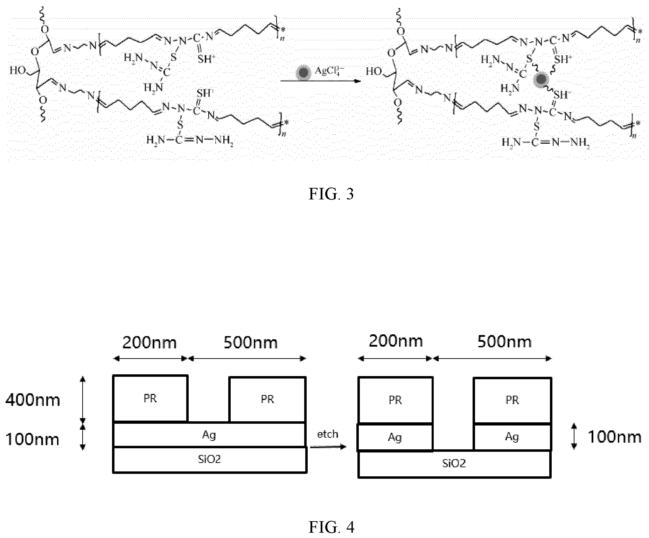

The purpose of the filter screen is to filter the large-particle silver agglomeration by-products which are filtered by the vacuum system. The size of the filter screen can be adjusted according to the actual size of the silver by-product during the etching process. By the method combining physical filtration and chemical adsorption, the by-products generated in the silver etching process can be effectively removed. Taking PWP-OX-TSC as an example, the principle of chemisorption is as illustrated in FIG. 3.

After adsorption occurs, a tautomerism peak of a thiol group in a thiourea group disappears, the main reason is that an S-containing group in the PWP-OX-TSC plays a role in the adsorption process. The protonation of the C-S group increases the binding energy of the C-S group, S ligand is protonated under acidic conditions, causing electrostatic interactions between positively charged PWP-OX-TSC and silver play an electrostatic role, so that the silver is adsorbed on the surface of the PWP-OX-TSC in the form of positively charged ions.

The following provides an embodiment of an improved silver etching process based on the innovation points of the present disclosure, which is convenient for a better understanding of the present disclosure.

The following three implementation examples are exemplified to describe the surface topography of the silver nanomaterial to be etched, as illustrated in FIG. 4.

### Example 1

The surface topography of the silver nanomaterial to be etched is as illustrated in FIG. 4.

The angle of the ion beam A is 0° , the ion energy is 400 V, the ion acceleration bias voltage is 400 V, the pressure of the etching cavity is 2 mT, the gas flow is 100 sccm, the gas is argon, and the etching is stopped until the SiO₂ layer is etched.

The angle of the B ion beam is -75 °, the ion energy is 400 V, the ion acceleration bias voltage is 400 V, the pressure of the etching cavity is 2 mT, the gas flow is 100 sccm, the gas is argon, and the side wall of the silver is decorated steeply.

The by-product silver particles generated in the process can be pumped into the air pumping pipelines, and the specifications of the filter screen and the chemical adsorbent in the air pumping pipeline are as follows.
(1) A group of filter screens are respectively arranged at the positions a and b, the distance between the two groups of filter screens is 100 mm, the diameter of each filter screen is 40 mm (equal to the inner diameter of the IBE air exhaust pipeline), the material of the filter screens is quartz, each group of filter screens includes two layers of filter screens, and the interval between the two layers of filter screens is 2 mm. The aperture size of the outer layer filter screen is 2 mm, the aperture size of the inner layer filter screen is 0.5 mm (the filter screen proximity to the shadow part is taken as the inner layer filter screen), the area of the holes accounts for 50% of the area of the whole filter screen, and the two layers of filter screens are arranged in a staggered way.
(2) Chemical adsorbent composition: 50 wt% of active component 3-mercaptopropyltrimethoxysilane, 15 wt% of biomass charcoal and 35 wt% of calcium oxide. The carrier consists of 40 wt% of active carbon, 15 wt% of molecular sieve and 45 wt% of alumina, and the loading capacity of the active component is 20%.

The adsorbent profile includes a spherical shape with a diameter of 1 mm.

The silver by-products are filtered through a filter screen, and large particles are blocked, and small particles are chemically adsorbed after passing through the filter screen, which can effectively reduce the silver etching by-products.

### Example 2

The angle of the ion beam A is 0 °, the ion energy is 400 V, the ion acceleration bias is 400 V, the pressure of the etching cavity is 2 mT, the gas flow is 100 sccm, the gas is argon, and the etching is stopped until the SiO₂ layer is etched.

The angle of the B ion beam is -75 °, the ion energy is 400 V, the ion acceleration bias voltage is 400 V, the pressure of the etching cavity is 2 mT, the gas flow is 100 sccm, the gas is argon, and the side wall of the silver is decorated steeply.

The by-product silver particles generated in the process can be pumped into the air pumping pipelines, and the specifications of the filter screen and the chemical adsorbent in the air pumping pipeline are as follows.
(1) A group of filter screens are respectively arranged at the positions a and b, the distance between the two groups of filter screens is 50 mm, the diameter of each filter screen is 40 mm (equal to the inner diameter of the IBE air exhaust pipeline), the material of the filter screens is quartz, each group of filter screens includes two layers of filter screens, and the interval between the two layers of filter screens is 2 mm. The aperture size of the outer layer filter screen is 2 mm, the aperture size of the inner layer filter screen is 0.5 mm (the filter screen proximity to the shadow part is taken as the inner layer filter screen), the area of the holes accounts for 50 % of the area of the whole filter screen, and the two layers of filter screens are arranged in a staggered way.
(2) Chemical adsorbent composition: 50 wt% of active component 3-mercaptopropyltrimethoxysilane, 15 wt% of biomass charcoal and 35 wt% of calcium oxide. The carrier consists of 40 wt% of active carbon, 15 wt% of molecular sieve and 45 wt% of alumina, and the loading capacity of the active component is 20%.

The adsorbent profile includes a sphere with a diameter of 1 mm.

The silver by-products are filtered through a filter screen, large particles are blocked, and small particles are incompletely adsorbed due to the insufficient filling amount of the adsorbent after passing through the filter screen, causing a small amount of small particles to be pumped into the pump.

### Example 3

The angle of the ion beam A is 0 °, the ion energy is 400 V, the ion acceleration bias voltage is 400 V, the pressure of the etching cavity is 2 mT, the gas flow is 100 sccm, the gas is argon, and the etching is stopped until the SiO₂ layer is etched.

The angle of the ion beam B is -75 °, the ion energy is 400 V, the ion acceleration bias voltage is 400 V, the pressure of the etching cavity is 2 mT, the gas flow is 100 sccm, the gas is argon, and the side wall of the silver is decorated steeply.

The by-product silver particles generated in the process can be pumped into the air pumping pipelines, and the specifications of the filter screen and the chemical adsorbent in the air pumping pipeline are as follows.
(1)A group of filter screens are respectively arranged at the positions a and b, the distance between the two groups of filter screens is 100 mm, the diameter of each filter screen is 40 mm (equal to the inner diameter of the IBE air exhaust pipeline), the material of the filter screens is quartz, each group of filter screens includes two layers of filter screens, and the interval between the two layers of filter screens is 2 mm. The aperture size of the outer layer filter screen is 2 mm, the aperture size of the inner layer filter screen is 0.5 mm (the filter screen proximity to the shadow part is taken as the inner layer filter screen), the area of the holes accounts for 50% of the area of the whole filter screen, and the two layers of filter screens are arranged in a staggered way.
(2) Chemical adsorbent composition: 50 wt% of active component 3-mercaptopropyltrimethoxysilane, 15 wt% of biomass charcoal and 35 wt% of calcium oxide. The carrier consists of 40 wt% of active carbon, 15 wt% of molecular sieve and 45 wt% of alumina, and the loading capacity of the active component is 50%.

The adsorbent profile includes a sphere with a diameter of 1 mm.

The silver by-products are filtered through a filter screen, and the large particles are blocked. After the small particles pass through the filter screen, due to the increase in the loading capacity of the active component of the adsorbent, there will be a better absorption effect on small particles of silver. The silver particles generated during the IBE etching process can be completely removed.

It will be understood by those skilled in the art that, unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the prior art and will not be interpreted in an idealized or overly formal sense unless expressly so defined herein.

The above embodiments are merely for illustrating the technical idea of the present disclosure, and the technical idea of the present disclosure is not limited thereto, and any modifications made on the basis of the technical solution according to the technical idea of the present disclosure fall within the protection scope of the present disclosure. While the embodiments of the present disclosure have been described in detail, the present disclosure is not limited to the above embodiments as long as the embodiments fall within the scope of the invention which is defined by the claims.

## Claims

1. A method for reducing agglomeration of silver etching by-products, comprising:
Step 1, providing at least one group of filter screen groups in a vacuum tube connecting a dry pump and an Ion Beam Etching (IBE) chamber, wherein an interval between adjacent filter screen groups of the at least one group of filter screen groups is 50 mm to 500 mm, each group of filter screen groups includes 1 to 3 layers of filter screens, and an interval between adjacent filter screens is 0.5 mm to 5 mm; and
Step 2, filling a chemical adsorbent between the filter screens.

2. The method according to claim 1, wherein in Step 1, the groups of filter screen groups are provided with at least 2 groups.

3. The method according to claim 1, wherein in Step 2, the chemical adsorbent includes an active component and a carrier, wherein the active component includes one or more of 30 wt% to 80 wt% of sulfhydryl compound, 10 wt% to 30 wt% of biomass charcoal and 10 wt% to 30 wt% of alkali metal compound.

4. The method according to claim 3, wherein in Step 2, the carrier includes 20 wt% to 30 wt% of activated carbon, 5 wt% to 15 wt% of molecular sieve and 40 wt% to 80 wt% of alumina, and a loading amount of the active component is 10 wt% to 50 wt%.

5. The method according to claim 3, wherein the sulfhydryl compound includes one or more of 3-mercaptopropyltrimethoxysilane, mercaptopropionic acid, mercaptoethylamine, glutathione and cellulose PWP-OX-TSC crosslinked based on sulfhydryl modified glutaraldehyde.

6. The method according to claim 3, wherein the alkali metal compound includes one or more of magnesium oxide, calcium oxide and chromium hemitrioxide.

7. The method according to claim 1, wherein the chemical adsorbent is spherical, granular, columnar or strip-shaped.

8. The method according to claim 1, wherein a material of the filter screen is stainless steel, quartz or ceramic.

9. The method according to claim 1, wherein aperture sizes of the filter screens in each filter screen group are sequentially reduced from an outer filter screen to an inner filter screen, an aperture size of an outermost filter screen is 2 mm to 5 mm, and an aperture size of an innermost filter screen is 0.5 mm to 1.5 mm.

10. The method according to claim 1, wherein meshes of the adjacent filter screens are distributed in a staggered manner.

## Patentansprüche

1. Verfahren zur Verringerung der Agglomeration von Silberätznebenprodukten, umfassend:
Schritt 1, Bereitstellen von zumindest einer Gruppe von Filtersiebgruppen in einem Vakuumrohr, das eine Trockenpumpe und eine Ionenstrahlätz(IBE-)Kammer verbindet, wobei ein Intervall zwischen benachbarten Filtersiebgruppen der zumindest einen Gruppe von Filtersiebgruppen 50 mm bis 500 mm ist, jede Gruppe von Filtersiebgruppen 1 bis 3 Schichten von Filtersieben beinhaltet und ein Intervall zwischen benachbarten Filtersieben 0,5 mm bis 5 mm ist; und
Schritt 2, Füllen eines chemischen Adsorptionsmittels zwischen die Filtersiebe.

2. Verfahren nach Anspruch 1, wobei in Schritt 1 die Gruppen von Filtersiebgruppen mit zumindest 2 Gruppen bereitgestellt sind.

3. Verfahren nach Anspruch 1, wobei in Schritt 2 das chemische Adsorptionsmittel eine aktive Komponente und einen Träger beinhaltet, wobei die aktive Komponente eines oder mehrere von 30 Gew.-% bis 80 Gew.-% Sulfhydrylverbindung, 10 Gew.-% bis 30 Gew.-% Biomassekohle und 10 Gew.-% bis 30 Gew.-% Alkalimetallverbindung beinhaltet.

4. Verfahren nach Anspruch 3, wobei in Schritt 2 der Träger 20 Gew.-% bis 30 Gew.-% Aktivkohle, 5 Gew.-% bis 15 Gew.-% Molekularsieb und 40 Gew.-% bis 80 Gew.-% Aluminiumoxid beinhaltet und eine Beladungsmenge der aktiven Komponente 10 Gew.-% bis 50 Gew.-% ist.

5. Verfahren nach Anspruch 3, wobei die Sulfhydrylverbindung eines oder mehrere von 3-Mercaptopropyltrimethoxysilan, Mercaptopropionsäure, Mercaptoethylamin, Glutathion und Cellulose PWP-OX-TSC vernetzt basierend auf sulfhydrylmodifiziertem Glutaraldehyd beinhaltet.

6. Verfahren nach Anspruch 3, wobei die Alkalimetallverbindung eines oder mehrere von Magnesiumoxid, Calciumoxid und Chromhemitrioxid beinhaltet.

7. Verfahren nach Anspruch 1, wobei das chemische Adsorptionsmittel kugelförmig, körnig, säulenförmig oder streifenförmig ist.

8. Verfahren nach Anspruch 1, wobei ein Material des Filtersiebs Edelstahl, Quarz oder Keramik ist.

9. Verfahren nach Anspruch 1, wobei Öffnungsgrößen der Filtersiebe in jeder Filtersiebgruppe nacheinander von einem äußeren Filtersieb zu einem inneren Filtersieb verringert sind, eine Öffnungsgröße eines äußersten Filtersiebs 2 mm bis 5 mm ist und eine Öffnungsgröße eines innersten Filtersiebs 0,5 mm bis 1,5 mm ist.

10. Verfahren nach Anspruch 1, wobei Maschen der benachbarten Filtersiebe auf eine versetzte Weise verteilt sind.

## Revendications

1. Procédé permettant de réduire l'agglomération de sous-produits de gravure d'argent, comprenant :
Étape 1, la fourniture d'au moins un groupe de groupes de tamis filtrants dans un tube à vide reliant une pompe sèche et une chambre de gravure par faisceau d'ions (IBE), un intervalle entre des groupes de tamis filtrants adjacents de l'au moins un groupe de groupes de tamis filtrants étant de 50 mm à 500 mm, chaque groupe de groupes de tamis filtrants comprenant 1 à 3 couches de tamis filtrants, et un intervalle entre des tamis filtrants adjacents étant de 0,5 mm à 5 mm ; et
Étape 2, le remplissage d'un adsorbant chimique entre les tamis filtrants.

2. Procédé selon la revendication 1, dans lequel à l'étape 1, les groupes de groupes de tamis filtrants sont dotés d'au moins 2 groupes.

3. Procédé selon la revendication 1, dans lequel, à l'étape 2, l'adsorbant chimique comprend un composant actif et un support, dans lequel le composant actif comprend un ou plusieurs parmi 30 % en poids à 80 % en poids de composé sulfhydryle, 10 % en poids à 30 % en poids de charbon de biomasse et 10 % en poids à 30 % en poids de composé de métal alcalin.

4. Procédé selon la revendication 3, dans lequel, à l'étape 2, le support comprend de 20 % en poids à 30 % en poids de charbon actif, de 5 % en poids à 15 % en poids de tamis moléculaire et de 40 % en poids à 80 % en poids d'alumine, et une quantité de charge du composant actif est de 10 % en poids à 50 % en poids.

5. Procédé selon la revendication 3, dans lequel le composé sulfhydryle comprend un ou plusieurs parmi le 3-mercaptopropyltriméthoxysilane, l'acide mercaptopropionique, la mercaptoéthylamine, le glutathion et la cellulose PWP-OX-TSC réticulée à base de glutaraldéhyde modifié par un sulfhydryle.

6. Procédé selon la revendication 3, dans lequel le composé de métal alcalin comprend un ou plusieurs parmi l'oxyde de magnésium, l'oxyde de calcium et l'hémitrioxyde de chrome.

7. Procédé selon la revendication 1, dans lequel l'adsorbant chimique est sphérique, granulaire, colonnaire ou en forme de bande.

8. Procédé selon la revendication 1, dans lequel un matériau du tamis filtrant est de l'acier inoxydable, du quartz ou de la céramique.

9. Procédé selon la revendication 1, dans lequel les tailles d'ouverture des tamis filtrants dans chaque groupe de tamis filtrants sont réduites séquentiellement d'un tamis filtrant externe à un tamis filtrant interne, une taille d'ouverture d'un tamis filtrant le plus externe est de 2 mm à 5 mm, et une taille d'ouverture d'un tamis filtrant le plus interne est de 0,5 mm à 1,5 mm.

10. Procédé selon la revendication 1, dans lequel les mailles des tamis filtrants adjacents sont réparties de manière décalée.
